# EUROPÄISCHE PATENTSCHRIFT

(11) **EP 3 138 122 B1**
(45) Veröffentlichungstag und Bekanntmachung des Hinweises auf die Patenterteilung: **29.09.2021**
(21) Anmeldenummer: 15712953.7
(22) Anmeldetag: 31.03.2015
(51) Int. Cl.: H01L 21/66, H01L 21/67, H01L 21/683

(54) **VERFAHREN UND VORRICHTUNG ZUM VERGLEICHMÄSSIGEN EINES SUBSTRATSTAPELS**
METHOD AND DEVICE FOR EVENING OUT A SUBSTRATE STACK
PROCÉDÉ ET DISPOSITIF POUR UNIFORMISER UN EMPILEMENT DE SUBSTRATS

(30) Priorität: 30.04.2014 DE 102014106100
(43) Veröffentlichungstag der Anmeldung: 08.03.2017
(73) Patentinhaber: Ev Group E. Thallner GmbH, 4782 St. Florian am Inn (AT)
(72) Erfinder: BURGGRAF, Jürgen, A-4780 Schärding (AT); LINDNER, Friedrich Paul, A-4780 Schärding (AT)
(74) Vertreter: Schneider, Sascha
(86) Internationale Anmeldenummer: PCT/EP2015/057054
(87) Internationale Veröffentlichungsnummer: WO 2015/165679

(56) Entgegenhaltungen:
- EP-A1- 0 511 777
- DE-A1- 10 052 293
- US-A- 5 733 182
- US-A1- 2012 024 456
- NIKLAUS F ET AL: "Adhesive wafer bonding", JOURNAL OF APPLIED PHYSICS, AMERICAN INSTITUTE OF PHYSICS, US, Bd. 99, Nr. 3, 9. Februar 2006 (2006-02-09), Seiten 31101-031101, XP012083688, ISSN: 0021-8979, DOI: 10.1063/1.2168512
- None

## Beschreibung

Die vorliegende Erfindung betrifft ein Verfahren gemäß Patentanspruch 1.

In der modernen Halbleiterindustrie ist die Reduktion der Schichtdicke eines Substrats eine unabdingbare Voraussetzung für die stetig voranschreitende Miniaturisierung der Halbleiterbauelemente. Wurden vor einigen Jahren aktive und passive Bauteile nur auf einem einzelnen Substrat, insbesondere einem Wafer, hergestellt, werden Substrate unterschiedlicher Funktionalität heute zueinander ausgerichtet und miteinander verbondet. Die Kontaktierung zwischen den einzelnen funktionalen Einheiten erfolgt dabei vorzugsweise über Siliziumdurchkontaktierungen (engl.: through silicon vias, TSVs). Die TSVs erlauben dabei eine direkte Herstellung einer elektrisch leitfähigen Verbindung zwischen den Substraten.

Einer der kritischsten Prozesse bei der Herstellung eines solchen Multisubstratstapels ist der Rückdünnprozess. Bei einem Rückdünnprozesses wird ein Substrat mit einem Durchmesser von meist mehreren hundert Millimetern auf eine Schichtdicke von bis zu unter 50 µm gedünnt. Das Substrat wird daher während des Rückdünnprozesses mit einem Trägersubstrat mechanisch stabilisiert. Darüber hinaus soll die Stabilisierungstechnologie auch eine Weiterverarbeitung, einen Transport, sowie eine Lagerung des wenige Mikrometer dicken Substrats erlauben.

Die am häufigsten verwendete Trägertechnologie ist das sogenannte temporäre Bonden. Beim temporären Bonden wird ein Temporärkleber auf den Produktwafer (der rückgedünnt werden soll) und/oder das Trägersubstrat aufgebracht. Danach erfolgt ein temporärer Bondvorgang zwischen dem Produktsubstrat und dem Trägersubstrat. Dabei ist es sehr oft so, dass die Produktsubstratseite, die mit dem Temporärkleber am Trägerwafer fixiert wird, bereits über funktionale Einheiten verfügt. Bei den funktionalen Einheiten kann es sich um Mikrochips, LEDs, MEMS, RDLs oder Lötkugeln (engl.: bumps) handeln. Die Schichtdicke des Temporärklebers muss entsprechend größer sein als die maximale Höhe der funktionalen Einheiten, um eine vollständige Einbettung der funktionalen Einheiten im Kleber zu gewährleisten.

Ein sehr großes Problem im Stand der Technik ist die sogenannten Totale Dickenvariation (engl.: total thickness variation, TTV). Darunter versteht man die Differenz zwischen der maximalen und der minimalen Dicke eines Objekts entlang einer vorgegebenen Richtung oder einer Ebene. Beispielsweise versteht man unter dem TTV eines Siliziumwafers die Differenz aus der an einer Stelle des Siliziumwafers vorzufindenden maximalen Dicke und seiner an einer anderen Stelle vorzufindenden minimalen Dicke.

Das Konzept des TTVs kann auch auf zusammengesetzte Objekte erweitert werden. So wird in der Halbleiterindustrie regelmäßig die Dickenvariation eines gebondeten Substratstapels gemessen. Dabei wird der Substratstapel mit der nach außen zeigenden Oberfläche seines ersten Substrats auf einer möglichst planaren Ebene eines Messgeräts abgelegt. Danach erfolgt eine Relativbewegung des Substratstapels in Bezug zu einem Sensor. Bei dem Sensor handelt es sich meistens um ein Laserinterferometer. Mit einem Laserinterferometer kann man Dickenänderungen bis in den Nanometerbereich detektieren und feststellen. Durch die Relativbewegung zwischen dem gebondeten Substratstapel und dem Laserinterferometer erfolgt eine Vermessung der Substratstapeldicke entlang der Messrichtung. Aus dem so erhaltenen Profil können Schichtdickenkarten sowie die maximale und die minimale Schichtdicke, und damit der TTV, bestimmt werden.

Die Kenntnis der TTV ist vor allem für jene Prozesse wichtig, die nach dem Bonden auf das Produktsubstrat angewandt werden, allen voran Rückdünn- und Ätzprozesse. Ein zu großer TTV sorgt nämlich für eine inhomogene Dickenabtragung und führt damit im schlimmsten Fall zu einer Zerstörung des Produktsubstrats.

Aus der US Patentschrift 5733182 ist ein Verfahrung zur Vergleichmäßigung der Dicke eines SOI-Wafers bekannt, bei dem durch Stifte beim Polieren eine lokal unterschiedliche Druckbeaufschlagung erfolgt.

Aufgabe der vorliegenden Erfindung ist es, ein Verfahren und eine Vorrichtung anzugeben, mit welchen die Dickenvariation vermindert, und daher verbessert, werden kann.

Diese Aufgabe wird mit den Merkmalen des Patentanspruchs 1 gelöst. Vorteilhafte Weiterbildungen der Erfindung sind in den Unteransprüchen angegeben.

Grundgedanke der vorliegenden Erfindung ist es, eine Vergleichmäßigung der Dickenvariation eines aus einem Trägersubstrat, und einem Produktsubstrat, mittels einer Klebeschicht verbundenen Waferstapels durch lokale Beaufschlagung lokaler Dickenmaxima, mittels einer mindestens eine Beaufschlagungseinheit aufweisenden Beaufschlagungseinrichtung durchzuführen. Im weiteren Verlauf der Patentschrift wird die Beaufschlagung von Dickenmaxima beschrieben.

Ein Produktwafer ist dünner als der zur Stützung des Produktwafers vorgesehene Trägerwafer.

Vergleichmäßigung im Sinne der vorliegenden Erfindung bedeutet insbesondere, dass die Dickenvariation durch die Ausführung des erfindungsgemäßen Verfahrens um 25%, vorzugsweise um 50%, noch bevorzugter um mindestens 75%, am bevorzugtesten um mindestens 90%, am allerbevorzugtesten um mindestens 95% reduziert wird.

Die Erfindung betrifft ein Verfahren, um die totale Dickenvariation eines gebondeten Substratstapels zu reduzieren. Ein Erfindungsaspekt liegt in einer **Ermittlung der X-Y-Position lokaler Maxima,** in Kombination mit einer Vorrichtung, die lokal auf den Waferstapel, insbesondere die Grenzfläche zwischen den beiden Wafern beziehungsweise eine Klebeschicht zwischen den Wafern, einwirken kann, um Dickenschwankungen gezielt zu vergleichmäßigen. Das erfindungsgemäße Verfahren wird als post-bond-Prozess durchgeführt. Das erfindungsgemäße Verfahren wird zur Reduktion des TTV zwischen zwei Wafern und einer dazwischen liegenden Klebeschicht verwendet.

Die Erfindung betrifft ein Verfahren zur Reduktion, insbesondere zur vollständigen Eliminierung, der, insbesondere totalen, Dickenvariation eines Waferstapels.

Der fundamentale Vorteil des erfindungsgemäßen Verfahrens besteht in der Möglichkeit einer post-bond Reduktion des TTVs. Prozesstechnologisch wird man immer versuchen, den TTV bereits während des Bondens vollständig zu reduzieren. Die Erfahrung zeigt aber, dass selbst mit den effizientesten und modernsten Bondinganlagen eine vollständige Reduktion des TTVs nicht möglich ist.

Eine Anlage zur Durchführung des erfindungsgemäßen Verfahrens besteht insbesondere aus mindestens zwei Einheiten, nämlich:
- mindestens einer Messeinheit zur Vermessung der Dickenverteilung beziehungsweise X-Y-Position der Dickenmaxima sowie
- einer **Beaufschlagungseinrichtung zur gezielten Vergleichmäßigung von konvexen Wölbungen des** Waferstapels **beziehungsweise von Dickenmaxima des** Waferstapels.

Die folgende Beschreibung der Anlage bezieht sich auf einen mittels einer Verbindungsschicht verbundenen Substratstapel. Gemäß dem erfindungsgemäßen Verfahren nach Anspruch 1 besteht dieser Substratstapel aus einem mittels einer Klebeschicht verbundenen Waferstapel.

### Messeinheit

Im Folgenden wird eine Messeinheit beschrieben, die bei der Durchführung des erfindungsgemäßen Verfahrens verwendet werden kann. Die Messeinheit ist jedoch nicht Teil der beanspruchten Erfindung.

Die erste Einheit ist eine Messeinheit zur Vermessung der lokalen Dicken entlang einer Oberfläche eines Substratstapels, insbesondere entlang einer Oberfläche des Produktsubstrats. Aus der Vermessung der Dicke an unterschiedlichen X-Y-Positionen entlang einer der vorgenannten Oberflächen können die, insbesondere totale, Dickenvariation und/oder X-Y-Position von Dickenmaxima und/oder Dickenminima bestimmt werden. Die X-Y-Positionen werden vorzugsweise in einer zentralen Steuerungseinheit zur Steuerung aller Verfahrensschritte und Vorrichtungsbauteile hinterlegt. Die Messeinheit besteht insbesondere aus einem Sender und einem Empfänger. Vorzugsweise sind der Sender und der Empfänger mechanisch miteinander gekoppelt. In einer noch bevorzugteren Ausführungsform sind der Sender und der Empfänger in einer Einheit, insbesondere einem, vorzugsweise geschlossenen, Gehäuse, gemeinsam verbaut. Nachfolgend wird vereinfacht von einem Sender gesprochen. Gemeint ist damit ein Bauteil, welches Signale, beispielsweise elektromagnetische Wellen oder akustische Schallwellen, aussendet, sie empfängt, auswertet und analysiert, um die oben genannten Dicken als für die Vergleichmäßigung weiterverwendbare Werte zu ermitteln.

In einer ersten Ausführungsform der Messeinheit handelt es sich um eine optische Messeinheit, insbesondere mit einem optischen Sender. Die optische Messeinheit weist vorzugsweise ein Interferometer auf. Bei dem Interferometer kann es sich um ein monochromatisches, oder gemäß einer bevorzugten Ausführungsform um ein polychromatisches Weißlichtinterferometer handeln. In einer speziellen Ausführungsform handelt es sich bei dem Interferometer um ein Infrarot-Interferometer.

In einer zweiten Ausführungsform ist die Messeinheit als akustische Messeinheit, insbesondere mit einem akustischen Sensor, ausgebildet. Die akustische Messeinheit weist vorzugsweise einen Ultraschallsender auf. Zur Einkoppelung des Ultraschallsignals in den Substratstapel wird vorzugsweise ein Fluid, insbesondere eine Flüssigkeit, zwischen dem Sender und der Substratstapeloberfläche aufgetragen. Daher ist diese Art der Vermessung nicht bevorzugt.

Der Sender ist vorzugsweise starr beziehungsweise statisch in Bezug auf eine Grundplatte montiert. Die Grundplatte ist möglichst eben und dient zur Aufnahme eines, vorzugsweise entlang der Grundplatte beweglichen, Probenhalters, auf dem der Substratstapel fixierbar ist und zur Vermessung und/oder Vergleichmäßigung fixiert wird. Der bewegliche Probenhalter ermöglicht eine Relativbewegung zwischen dem Substratstapel und dem Sender und damit eine Vermessung der Schichtdicke des Substratstapels entlang der oben genannten Oberflächen.

Im weiteren Verlauf wird die Ebenheit als Maß für die Perfektion einer planaren Fläche, insbesondere eine Oberfläche, verwendet. Abweichungen von einer planaren Oberfläche ergeben sich durch Welligkeiten und Rauhigkeiten. Die Welligkeit einer Oberfläche zeichnet sich durch eine gewisse periodische Anhebung und Absenkung der Oberfläche, insbesondere im Millimeterbereich, seltener im Mikrometerbereich, aus. Rauhigkeit hingegen ist ein eher aperiodisches Phänomen im Mikro- bzw.
Nanometerbereich. Die genaue Definition derartiger Oberflächeneigenschaften ist jedem Fachmann der Oberflächenphysik-, Tribologie, des Maschinenbaus oder der Werkstoffwissenschaften bekannt. Um die unterschiedlichen Abweichungen von der idealen Oberfläche zu behandeln, wird im weiteren Verlauf der Begriff der Rauheit synonym für die vorgenannten Effekte sowie der Überlagerung aller derartigen Effekte verwendet. Die Rauheit wird entweder als mittlere Rauheit, quadratische Rauheit oder als gemittelte Rauhtiefe angegeben. Die ermittelten Werte für die mittlere Rauheit, die quadratische Rauheit und die gemittelte Rauhtiefe unterscheiden sich im Allgemeinen für dieselbe Messstrecke bzw. Messfläche, liegen aber im gleichen Größenordnungsbereich. Daher sind die folgenden Zahlenwertebereiche für die Rauheit entweder als Werte für die mittlere Rauheit, die quadratische Rauheit oder für die gemittelte Rauhtiefe zu verstehen.

Die Rauheit der Grundplatte ist so gering wie möglich, insbesondere kleiner als 100 µm, vorzugsweise kleiner als 10 µm, mit größerem Vorzug kleiner als 1 µm, mit größtem Vorzug kleiner als 100 nm, mit allergrößtem Vorzug kleiner als 10 nm, am bevorzugtesten kleiner als 1 nm. Die Grundplatte besteht vorzugsweise aus einem mechanisch starren, wenig plastisch verformbaren Material, insbesondere Granit. Der E-Modul der Grundplatte ist insbesondere größer als 0.01 GPa, vorzugsweise größer als 0.1 GPa, noch bevorzugter größer als 1 GPa, am bevorzugtesten größer als 100 GPa, am allerbevorzugtesten größer als 1000 GPa. Die hohe Oberflächenebenheit und somit geringe Rauheit wird insbesondere durch Schleif-, Polier-und Ätzverfahren erreicht.
Der Probenhalter bewegt sich vorzugsweise auf Luftlagern entlang der Grundplatte. Die Oberfläche des Probenhalters weist bevorzugt eine entsprechend geringe Rauheit auf. Die Rauheit der Probenhalteroberfläche ist insbesondere kleiner als 100 µm, vorzugsweise kleiner als 10 µm, mit größerem Vorzug kleiner als 1 µm, mit größtem Vorzug kleiner als 100 nm, mit allergrößtem Vorzug kleiner als 10 nm, am bevorzugtesten kleiner als 1 nm. Der E-Modul des Probenhalters ist insbesondere größer als 0.01 GPa, vorzugsweise größer als 0.1 GPa, noch bevorzugter größer als 1 GPa, am bevorzugtesten größer als 100 GPa, am allerbevorzugtesten größer als 1000 GPa.
In einer besonders bevorzugten Ausführungsform erfolgt die Ermittlung der positionsabhängigen Dicken in einem Zweischrittprozess. Im ersten Schritt werden die Dicken des Substratstapels durch Relativbewegung zwischen dem Substratstapel und dem Sender einschließlich deren X-Y-Positionen ermittelt. Danach erfolgt eine 180° Drehung des Substratstapels um seine Oberflächennormale und eine erneute Vermessung des Substratstapels. Die tatsächliche Dickenverteilung des Substratstapels lässt sich dann aus dem arithmetischen Mittelwert der beiden Dickenverteilungen vor und nach der Drehung berechnen. Voraussetzung für einen derartigen Mittelungsprozess ist die eindeutige Zuordnung der Substratstapelpunkte und X-Y-Positionen zwischen den beiden zueinander gedrehten Koordinatensystemen. Der Vorteil dieser Ausführungsform besteht vor allem darin, dass Unebenheiten des Probenhalters und/oder der Grundplatte durch eine statistische Mittelung der gemessenen Schichtdicken weniger Einfluss auf das gemittelte Endergebnis haben. Würde man eine Mehrfachvermessung eines jeden Punktes ohne die Drehung durchführen, erhielte man nur eine bessere Zählstatistik.

### Die Beaufschlagungseinrichtung

Im Folgenden wird eine Beaufschlagungseinrichtung beschrieben, die bei der Durchführung des erfindungsgemäßen Verfahrens verwendet werden kann. Die Beaufschlagungseinrichtung ist jedoch nicht Teil der beanspruchten Erfindung.

Bei der zweiten, insbesondere eigenständigen, Einheit beziehungsweise Vorrichtung handelt es sich um eine Beaufschlagungseinrichtung, **durch die der Substratstapel lokalen Beeinflussungen, insbesondere Verformungen ausgesetzt wird,** soweit eine solche zur Verringerung der TTV des Substratstapels notwendig ist. Bei den Beeinflussungen handelt es sich um mechanische Beeinflussungen.

Die vorher erstellte und in der, insbesondere softwaregesteuerten, Steuerungseinrichtung hinterlegte Dickenverteilung des Substratstapels wird nun verwendet, um lokale Extrema, (also Maxima) zu erkennen. Solche Extrema treten insbesondere bei Substratstapeln auf, die durch einen Temporärbond hergestellt wurden. Zumindest überwiegend weist der Substratstapel durch Inhomogenität der Temporärkleberdicke zu lokal unterschiedlichen Dicken. Weiterhin ist die Dicke, insbesondere vereinzelt oder untergeordnet, durch die Topographie des Produktsubstrats, durch Einschlüsse, Partikel oder thermische Belastung beeinflusst.

Ein Aspekt besteht darin, die Beaufschlagungseinrichtung zu verwenden, um gezielt lokale Extrema zu reduzieren. Insbesondere ist die Beaufschlagungseinrichtung analog der Messeinheit starr ausgelegt, entsprechend exakt gefertigt, belastbar und liefert reproduzierbare Ergebnisse. In besonderen Ausführungsformen wird die Beaufschlagungseinrichtung mit der Messeinheit kombiniert, insbesondere auf derselben Grundplatte angeordnet und fixiert. Damit wird eine kompakte Ausführungsform der Anlage geschaffen. Des Weiteren ist der Transportweg des Substratstapels zwischen der Messeinheit und der Beaufschlagungseinrichtung minimal. Ein weiterer Vorteil der Kombination von Messeinheit und Beaufschlagungseinrichtung ist die parallele Durchführung von Messung und lokalen Veränderung der Dicken.

Denkbar wäre es insbesondere, dass sich der Sender der Messeinheit an einer ersten Position und eine Beaufschlagungseinheit der Beaufschlagungseinrichtung an einer zweiten Position der kombinierten Ausführungsform befinden. Soweit der Substratstapel so über die Grundplatte bewegt wird, dass die X-Y-Position eines lokalen Maximums des Substratstapels zuerst die Position des Senders der Messeinheit und danach die Position der Beaufschlagungseinheit passiert, kann an einer ersten Position eine Dickenmessung und an einer zweiten Position simultan bereits die Änderung der Schichtdicke durchgeführt werden. Damit wird ein entsprechend höherer Durchsatz erreicht.

In einer ganz besonderen Ausführungsform sind die Messeinheit und die Beaufschlagungseinrichtung separat voneinander angeordnet, vorzugsweise in unterschiedlichen Modulen derselben Fabrik (engl.: Fab) oder sogar in Modulen unterschiedlicher Fabriken. Dadurch wird die Vermessung der Dickenverteilung von der Vergleichmäßigung des Substratstapels getrennt und es wird möglich, Messeinheiten und Beaufschlagungseinrichtungen verschiedener Hersteller miteinander zu kombinieren.

Die Beaufschlagungseinrichtung kann als Punktbeaufschlagungseinrichtung oder als Flächenbeaufschlagungseinrichtungen ausgebildet sein. Die Flächenbeaufschlagungseinrichtung ist die bevorzugte Ausführungsform, da der Durchsatz für die Vergleichmäßigung deutlich höher ist. Sie besteht insbesondere aus einem Feld von Punktbeaufschlagungseinrichtungen, wobei jede der Punktbeaufschlagungseinrichtungen insbesondere separat angesteuert und kontrolliert werden kann. Die Funktionsweise des erfindungsgemäßen Verfahrens und der Vorrichtung wird allerdings besonders klar und einfach durch die Darstellung der Funktionsweise einer Punktbeaufschlagungseinrichtung.

### Punktbeaufschlagungseinrichtungen

In einer ersten Ausführungsform weist die Beaufschlagungseinrichtung genau eine Beaufschlagungseinheit auf, die in der Lage ist, einen mechanischen Druck auf die Oberfläche des Substratstapels, insbesondere auf die Oberfläche des Produktsubstrats, auszuüben. Die Beaufschlagungseinheit ist mit Vorzug stiftförmig ausgeprägt. Die mechanische Druckbeanspruchung bewirkt auf die konvexe Wölbung eines lokalen Maximums ein Verfließen der Verbindungsschicht zwischen dem Trägersubstrat und dem Produktsubstrat und damit ein Vergleichmäßigen der Dicke der Verbindungsschicht und somit des Substratstapels. Die Spitze des Stiftes kann unterschiedliche Formen aufweisen. So sind spitz zulaufende Formen, abgerundete, insbesondere kugelförmige, oder rechteckige Formen denkbar.

Die Punktbeaufschlagungseinrichtung und/oder der Probenhalter wird über eine entsprechende Software und/oder Firmware und/oder Hardware so gesteuert, **dass die zu beaufschlagenden konvexen Ausbeulungen beziehungsweise Dickenmaxima einzeln angefahren** und durch die Beanspruchung der Beaufschlagungseinheit auf die Oberfläche möglichst weitgehend planarisiert werden. Hierdurch wird der TTV des Substratstapels minimiert.

Die Beaufschlagungseinheit ist gemäß einer bevorzugten Ausführungsform in jeder Ausführungsform mindestens entlang der z-Achse bewegbar.

Bei den folgenden Ausführungsformen handelt es sich um Vorrichtungen, die aus mehreren Beaufschlagungseinheiten bestehen. Die Beaufschlagungseinheiten sind, insbesondere in einer Ruheposition fluchtend, nebeneinander angeordnet. Die Anordnung der Beaufschlagungseinheiten ist vorzugsweise regelmäßig, insbesondere erfolgt die Anordnung entlang eines rechteckigen Gitters. Denkbar wäre auch eine Anordnung die Beaufschlagungseinheiten in mehreren, zueinander konzentrischen, Kreisen, deren Radius entsprechend zunimmt. Eine weitere denkbare Möglichkeit wäre eine Anordnung der Beaufschlagungseinheiten entlang eines hexagonalen oder flächenzentrierten Gitters.

In einer Ausführungsform wird eine in Beaufschlagungsrichtung der Beaufschlagungseinheiten dehnbare und flexible Membran vor die Beaufschlagungseinheiten gespannt. Die Membran wird durch die Beaufschlagungseinheiten in eine Beaufschlagungsstellung zumindest lokal verformt. Die Membran weist im Gegensatz zu den diskreten Beaufschlagungseinheiten eine kontinuierliche, insbesondere eine gesamte Beaufschlagungsseite der Flächenbeaufschlagungseinrichtung bedeckende, Oberfläche dar. Diese Ausführungsform führt zu einer verbesserten flächenmäßigen Beanspruchung der Oberfläche des Produkt substrats/Substratstapels.

Die Membran kann grundsätzlich aus jedem beliebigen Material bestehen, ist allerdings vorzugsweise verschleißfest, temperaturresistent, elastisch und/oder besitzt eine entsprechend hohe Festigkeit.

Für die Härte existieren verschiedene, technologische Kenngrößen. Das korrekte Härtemessverfahren hängt von vielen Einflussfaktoren ab. Die wichtigsten Faktoren sind das zu prüfende Material, sowie der Prüfkörper. Metalle und Keramiken, also Festkörper mit entsprechend hoher Festigkeit und/oder entsprechendem Plastizitätsvermögen, werden vorwiegend, aber nicht ausschließlich mit Härteverfahren nach Rockwell, Brinell und Vickers getestet. Die Umrechnung der einzelnen Härtemesswerte ist bedingt möglich. Entsprechende Tabellen und Formeln existieren und sind dem Fachmann bekannt. Es muss allerdings erwähnt werden, dass eine exakte Umrechnung nicht immer möglich bzw. ungenau ist. Folgende Härtemessewerte beziehen sich auf die Härte nach Vickers. Die Vickershärte des Membranmaterials ist insbesondere größer als 100, vorzugsweise größer als 500, noch bevorzugter größer als 1000, am bevorzugtesten größer als 5000, am allerbevorzugtesten größer als 10000. In besonderen Ausführungsformen können auch Membranmaterialien bevorzugt verwendet werden, die eine sehr geringe Härte besitzen und sich daher besonders gut an die Oberfläche des Substrats anpassen können. Diese besonders bevorzugten Membranmaterialien bestehen vor allem aus Kunststoffen, insbesondere aus Kunststoffen, die bis zu mehreren hundert Grad Celsius temperaturstabil sind. Das bevorzugte Härtemessverfahren für Kunststoffe ist das Verfahren nach Shore. Die Shorehärte der Kunststoffe ist insbesondere kleiner als 100, vorzugsweise kleiner als 75, noch bevorzugter kleiner als 50, am bevorzugtesten kleiner als 25, am allerbevorzugtesten kleiner als 5. Die genaue Definition kann in den entsprechenden Normen DIN ISO 7619-1 und DIN EN ISO 868 nachgelesen werden.

Temperaturresistenz bedeutet in diesem Zusammenhang, dass die Membran bei erhöhter Temperatur nicht zu kriechen beginnt, also dass keine plastische Verformung durch Diffusionsprozesse unter Last entsteht. Um nicht auf die näheren physikalischen und chemischen Prozesse des Kriechens eingehen zu müssen, wird ein kriechresistenter Werkstoff dadurch gekennzeichnet, dass der entsprechende Werkstoff bis zu einer maximalen Spannung und einer maximalen Temperatur keine plastische Verformung als Funktion der Zeit erfährt. Die maximale Temperatur ist insbesondere größer als 0 °C, vorzugsweise größer als 50 °C, noch bevorzugter größer als 100 °C, am bevorzugtesten größer als 250 °C, am aller bevorzugtesten größer als 500 °C. Die maximale Spannung ist insbesondere größer als 10E6 Pa, vorzugsweise größer als 10E7 Pa, mit größerem Vorzug größer als 10E8 Pa, am bevorzugtesten größer als 10E9 Pa.

Die Elastizität wird durch den E-Modul beschrieben. Der E-Modul der Membran liegt insbesondere zwischen 1 GPa und 1000 GPa, bevorzugt zwischen 10 GPa und 1000 GPa, mit größerem Vorzug zwischen 25 GPa und 1000 GPa, mit größtem Vorzug zwischen 50 GPa und 1000 GPa, am bevorzugtesten zwischen 100 GPa und 1000 GPa. Der E-Modul von einigen Stahlsorten liegt beispielsweise bei ca. 200 GPa.

Die Streckgrenze gibt die maximale Spannung an, bei der ein Körper sich gerade noch nicht plastisch verformt. Bevorzugt werden Werkstoffe für die Membran, die eine hohe Streckgrenze besitzen, um bleibende plastische Verformung zu unterbinden. Die Streckgrenze des Membranwerkstoffes ist insbesondere größer als 1 MPa, vorzugsweise größer als 10 MPa, noch bevorzugter größer als 100 MPa, am bevorzugtesten größer als 500 MPa, am aller bevorzugtesten größer als 1000 MPa.

Besonders bevorzugt werden Membranwerkstoffe, welche die Oberfläche des Produktsubstrats nicht kontaminieren. Die Membranwerkstoffe sollten daher vorzugsweise frei von allen für Halbleiteranwendungen kritischen Elementen, insbesondere Metallen wie Kupfer, Gold, Molybdän und Titan sein. Bevorzugt wird ein Membranwerkstoff verwendet, der auf einem Polymer und/oder einem Kohlenstoffmaterial basiert.

In einer Ausführungsform handelt es sich bei den Beaufschlagungseinheiten um voneinander abgeschottete, insbesondere separat mit Druck beaufschlagbare und/oder ansteuerbare, Druckkammern. Die Druckkammern werden in Richtung der zu beaufschlagenden Oberfläche des Produktsubstrats von einer Membran und seitlich von elastisch verformbaren Druckkammerwänden umschlossen. Die Druckkammern sind bevorzugt einzeln mit Überdruck und/oder Unterdruck beaufschlagbar und erlauben eine Verformung der Membran und damit bei Kontakt mit der Oberfläche des Produktsubstrats eine Beaufschlagung der konvexen Wölbungen.

Die Druckkammern weisen insbesondere einen Druck zwischen 10⁻⁸ mbarund 10 bar, vorzugsweise zwischen 10⁻⁸ mbar und 8 bar, noch bevorzugter zwischen 10⁻⁸ mbar und 6 bar, am bevorzugtesten zwischen 10⁻⁸ mbar und 4 bar, am allerbevorzugtesten zwischen 10⁻⁸ mbar und 2 bar auf. Die Druckkammern können mit jedem beliebigen Fluid beaufschlagt werden, also mit Flüssigkeiten und/oder Gasen. Entsprechend handelt es sich um hydraulische und/oder pneumatische Druckkammern. Bevorzugt wird auf Flüssigkeiten verzichtet, so dass pneumatische Druckkammern bevorzugt sind.

Die Kombination einer Flächenbeaufschlagungseinrichtung mit einer Messeinheit ist - wie oben beschrieben - denkbar. Vorzugsweise wird zuerst der gesamte Substratstapel (insbesondere hinsichtlich seiner Dicke und/oder der Dicke einzelner Schichten des Substratstapels wie die Dicke des Produktsubstrats, Trägersubstrats und/oder der Verbindungsschicht) vermessen. Danach erfolgt die Verbesserung der Dickenvariation (TTV) in der Flächenbeaufschlagungseinrichtung. In einem weiteren, optionalen Schritt erfolgt dann die erneute Vermessung des Substratstapels. Sollte der ermittelte TTV kleiner sein als ein vorgegebener Grenzwert, so kann der Substratstapel weiterverarbeitet werden. Ist er größer, erfolgt eine erneute Verbesserung der Dickenvariation (TTV) mittels der Flächenbeaufschlagungseinrichtung.

In einer bevorzugten Ausführungsform sind die Flächenbeaufschlagungseinrichtung und die Messeinheit innerhalb einer Einheit oder innerhalb desselben Moduls angeordnet, wodurch der Wechsel zwischen der Vermessung des Substratstapels und der Verbesserung des TTVs beschleunigt wird.

### Anordnung und Form der Beaufschlagungseinheiten

Die Form die Beaufschlagungseinheiten, insbesondere an einer stirnseitig angeordneten Beaufschlagungsseite und/odereiner Mantelfläche, kann grundsätzlich beliebig sein, soweit dadurch die Oberfläche beaufschlagt werden kann. Es zeigt sich allerdings, dass sich gewisse Formen für besondere Einsatzgebiete eignen.

Die Mantelflächen der Beaufschlagungseinheiten sind bevorzugt als runde, insbesondere kreisrunde, oder eckige Zylinder geformt.

Die Beaufschlagungsseite (oder Beaufschlagungskopf) ist insbesondere rund zulaufend, flach, spitz zulaufend, kegelförmig flach zulaufend oder hexagonal flach geformt.

Flache Beaufschlagungsköpfe eignen sich besser zur Reduzierung konvexer Wölbungen sowie zur Wärmeübertragung.

Spitz zulaufende Beaufschlagungsköpfe sind vor allem dann von Bedeutung, wenn hohe elektrische und/oder magnetische Felder erzeugt und lokalisiert werden sollen.

Flache Beaufschlagungsköpfe mit hexagonaler Form sind besonders bevorzugt, da sie einerseits flach sind, eine Fläche vollständig bedecken können und durch ihre hexagonale Symmetrie eine optimale radiale Beziehung zu ihren entsprechenden Nachbarn besitzen.

Weitere Vorteile, Merkmale und Einzelheiten der Erfindung ergeben sich aus der nachfolgenden Beschreibung bevorzugter Ausführungsbeispiele sowie anhand der Zeichnungen. Diese zeigen in:
- Figur 1a: eine schematische Querschnittsdarstellung eines idealen Substratstapels ohne TTV,
- Figur 1b: eine schematische Querschnittsdarstellung eines realen Substratstapels mit Dickenvariation (TTV),
- Figur 1c: eine schematische Querschnittsdarstellung eines Bearbeitungsvorgangs (hier: Rückdünnen) eines realen Substratstapels,
- Figur 2: eine schematische Querschnittsdarstellung einer Ausführungsform einer Messeinheit,
- Figur 3: eine schematische Querschnittsdarstellung einer Ausführungsform einer Punktbeaufschlagungseinrichtung,
- Figur 4: eine schematische Querschnittsdarstellung einer Ausführungsform einer kombinierten Messeinheit und Punktbeaufschlagungseinrichtung,
- Figur 5a: eine schematische Querschnittsdarstellung eines erfindungsgemäßen ersten Bearbeitungsschritts einer Ausführungsform eines Verfahrens,
- Figur 5b: eine schematische Querschnittsdarstellung eines erfindungsgemäßen zweiten Bearbeitungsschritts der Ausführungsform gemäß Figur 5a,
- Figur 5c: eine schematische Querschnittsdarstellung eines erfindungsgemäßen dritten Bearbeitungsschritts der Ausführungsform gemäß Figur 5a,
- Figur 5d: eine schematische Querschnittsdarstellung eines erfindungsgemäßen optionalen vierten Bearbeitungsschritts der Ausführungsform gemäß Figur 5a,
- Figur 6a: eine schematische Querschnittsdarstellung einer Flächenbeaufschlagungseinrichtung gemäß einer ersten Ausführungsform,
- Figur 6b: eine schematische Querschnittsdarstellung einer Flächenbeaufschlagungseinrichtung gemäß einer zweiten Ausführungsform,
- Figur 7: eine schematische Querschnittsdarstellung einer Flächenbeaufschlagungseinrichtung gemäß einer dritten Ausführungsform,
- Figur 8: eine schematische Darstellung eines Querschnitts (jeweils links) sowie einer Unteransicht (jeweils rechts) von sechs Ausführungsformen eines Beaufschlagungskopfes und
- Figur 9: eine schematische Unteransicht einer vierten Ausführungsform einer Flächenbeaufschlagungseinrichtung mit einem Feld aus hexagonalen, flachen Beaufschlagungsköpfen.

In den Figuren sind gleiche oder gleichwirkende Bauteile mit den gleichen Bezugszeichen gekennzeichnet. Obwohl in der folgenden Beschreibung Bezug auf ein Trägersubstrat, ein Produktsubstrat und eine Verbindungsschicht genommen wird, handelt es sich im Verfahren gemäß der Erfindung um ein Trägerwafer, ein Produktwafer und eine Klebeschicht.

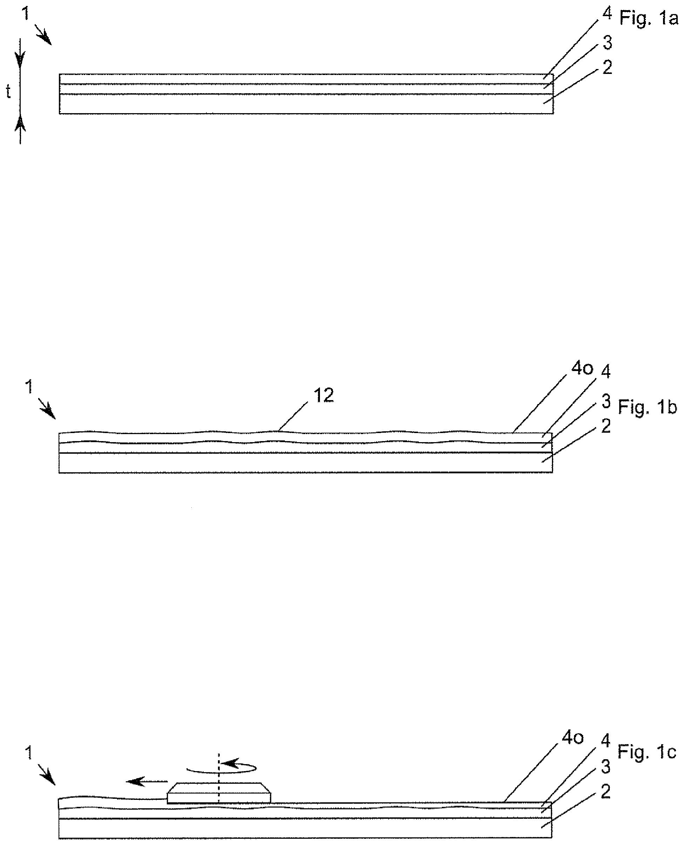

Figur 1a zeigt einen schematischen Querschnitt eines idealen Substratstapels 1, bestehend aus einem Trägersubstrat 2, einer als Temporärkleber ausgebildeten Verbindungsschicht 3 und einem Produktsubstrat 4. In dieser, technisch nicht oder mit unverhältnismäßigem Aufwand zu realisierenden Ausführungsform besitzen das Trägersubstrat 2, die Verbindungsschicht 3 und das Produktsubstrat 4 eine homogene Dicke, also eine Dickenvariation (TTV) von Null. Die homogenen Dicken des Trägersubstrats 2, der Verbindungsschicht 3 und des Produktsubstrat 4 führen damit zu einer homogenen Substratstapeldicke.

Figur 1b zeigt einen schematischen Querschnitt eines realen Substratstapels 1, bestehend aus einem Trägersubstrat 2, einer Verbindungsschicht 3 mit Dickenvariation und einem Produktsubstrat 4. Die Dickenvariation ist zumindest überwiegend, praktisch ausschließlich, durch die Verbindungsschicht 3 bedingt. Das Produktsubstrat 4 ist dünner als das Trägersubstrat 2, weshalb das Produktsubstrat 4 der Dickenvariation der Verbindungsschicht 3 im Wesentlichen folgt, zumal das Trägersubstrat 2 zumindest bei der Durchführung des erfindungsgemäßen Verfahrens auf einem ebenen Probenhalter 8 aufgenommen, insbesondere fixiert ist.

Klar erkennbar ist die inhomogene Substratstapeldicke t. Die Inhomogenität in der Substratstapeldicke t führt beim Rückdünnen (siehe Figur 1c) einer Oberfläche 4o des Produktsubstrats 4 zu einem entsprechenden inhomogenen Produktsubstrat 4. Konvex gekrümmte Abschnitte der Oberfläche 4o (lokale Maxima) werden stärker abgetragen, während konkav gekrümmte Abschnitte der Oberfläche 4o (lokale Minima) weniger abgetragen werden. Das gesamte Produktsubstrat 4 wäre nach einem Ablösevorgang inhomogen, obwohl es vorher eine einheitliche Dicke hatte.

Ein solcher Vorgang kann ausschließlich dadurch verhindert werden, indem gewährleistet wird, dass die inhomogene Dickenverteilung und damit der als Maßzahl geltende TTV des realen Substratstapels 1 durch die erfindungsgemäßen Ausführungsformen so weit reduziert wird, dass man einen idealen Substratstapel 1 erhält. Nachdem die erfindungsgemäße Ausführungsform einen realen Substratstapel 1 in einen idealen Substratstapel 1 umgewandelt hat, kann dieser auch entsprechend bearbeitet werden. Als idealer Substratstapel 1 wird ein Substratstapel 1 verstanden, der einen TTV-Wert unter einem festgelegten Grenzwert hat.

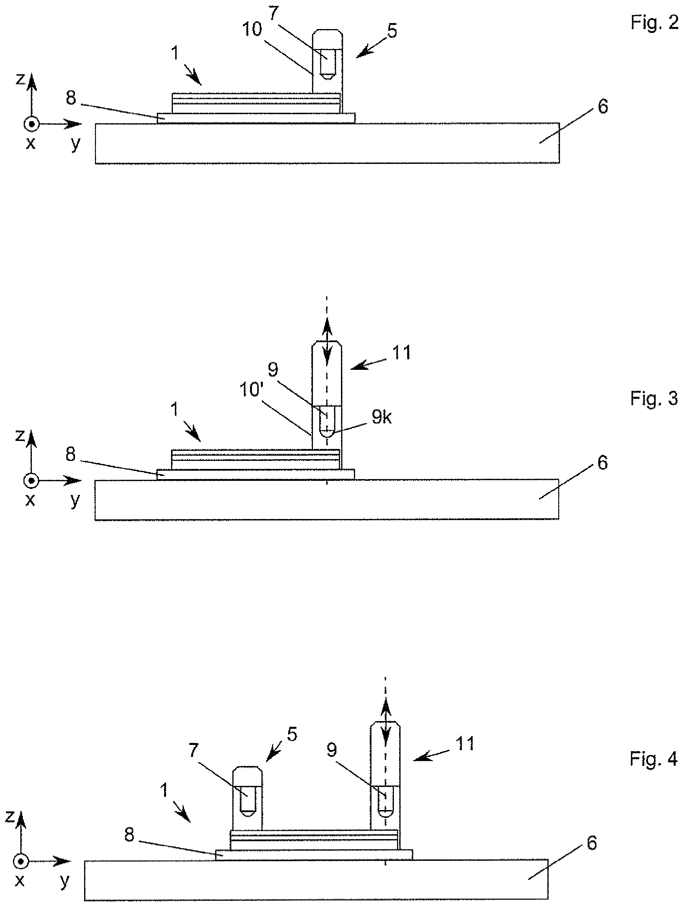

Die Figur 2 zeigt eine Messeinheit 5, bestehend aus einem Sensor 7, vorzugsweise einem Interferometer, noch bevorzugter einem Weißlichtinterferometer. Der Sensor 7 ist über Streben 10 mit einer massiven Grundplatte 6 fest verbunden. Die Grundplatte 6 dient als mechanischer Schwingungsdämpfer. Auf der Grundplatte 6 wird außerdem der Probenhalter 8, vorzugsweise auf einer Luftlagerung, in einer durch die Grundplatte definierten X-Y-Richtung bewegt.

Der Probenhalter 8 kann den Substratstapel 1 über unterschiedliche Fixierelemente (nicht eingezeichnet) fixieren. Bei den Fixierelementen kann es sich um Vakuumfixierungen, elektrostatische Fixierungen, mechanische Klemmen, adhäsive Oberflächen oder ähnliche Fixierungsmechanismen handeln. Diese sind dem Fachmann bekannt.

Der Probenhalter 8 ist translatorisch entlang der X- und Y-Richtung verfahrbar und kann vorzugsweise auch entlang der Z-Richtung (senkrecht zur X- und Y-Richtung) verfahren werden, sodass er eine Anhebung des Substratstapels 1 ermöglicht. In einer besonders bevorzugten ausführungsform kann der Probenhalter 8 um eine lokale Z-Achse gedreht werden und/oder um eine lokale X- und/oder Y-Achse gekippt werden.

Der erste erfindungsgemäße Schritt besteht in der Vermessung der Dickenverteilung des Substratstapels 1, daher der exakten Vermessung der Schichtdicke für jede X-Y-Position des Substratstapels 1 durch die Messeinheit 5. Die Messeinheit wird durch eine Steuerungseinrichtung (nicht dargestellt) gesteuert und die Messwerte werden für die spätere Nutzung bei der Steuerung einer Beaufschlagungseinrichtung 11 (siehe Figuren 3 bis 9) hinterlegt.

Figur 3 zeigt die hier als Punktbeaufschlagungseinrichtung ausgebildete Beaufschlagungseinrichtung 11, bestehend aus einer Beaufschlagungseinheit 9, die über Streben 10' mit der Grundplatte 6 verbunden ist. Die Punktbeaufschlagungseinrichtung 11 und der Probenhalter 8 werden mittels einer Software und/oder Firmware und/oder Hardware (Steuerungseinrichtung) gesteuert. Konvexe Wölbungen beziehungsweise Maxima 12 werden einzeln angefahren (durch Bewegung des Probenhalters 8 und/oder der Beaufschlagungseinheit 9 in X- und Y-Richtung) und durch Beaufschlagung der Oberfläche 4o mit der Beaufschlagungseinheit 9 möglichst planarisiert.

Die Beaufschlagungseinheit 9 wird hierzu entlang der Z-Richtung (siehe Pfeile in Figur 3) gehoben und gesenkt, um durch den Kontakt eines Beaufschlagungskopfes 9k mit der Oberfläche 4o, durch Entzerrung der konvexen Wölbung 12, eine Vergleichmäßigung der Substratstapeldicke t zu erreichen.

Bei der Beaufschlagungseinheit 9 handelt es sich mit Vorzug um einen Stift. Dementsprechend versteht man unter der Beanspruchung der konvexen Wölbung 12 eine mechanische Druckbeanspruchung. Die mechanische Druckbeanspruchung erzeugt auf die konvexe Wölbung 12 ein Verfließen und dadurch gleichmäßigeres Verteilen des Temporärklebers 2 zwischen dem Trägersubstrat 2 und dem Produktsubstrat 4.

Die Figur 4 zeigt eine besonders bevorzugte Ausführungsform, bei der die Messeinheit 5 mit dem Sensor 7 und die Beaufschlagungseinrichtung 11 mit der Beaufschlagungseinheit 9 in einer Einheit oder einem Modul miteinander kombiniert wurden. Dadurch kann eine entsprechend kompakte Messung und Vergleichmäßigung durchgeführt werden. Vor allem der Wechsel zwischen Messung und Vergleichmäßigung kann beliebig oft und vor allem entsprechend effektiv und schnell durchgeführt werden.

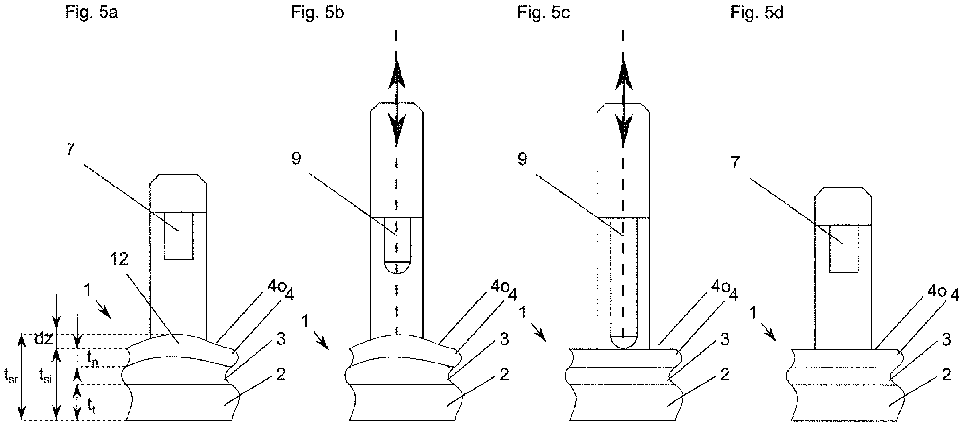

Figur 5a zeigt eine schematische Querschnittsdarstellung eines erfindungsgemäßen ersten Prozessschritts, bei dem eine bestimmte konvexe Wölbung 12 unter dem Sensor 7 positioniert wird. Der Sensor 7 misst die reale Substratstapeldicke tₛᵣ. Bei Kenntnis der Trägersubstratdicke tₜ und der Produktsubstratdicke tₚ kann die konvexe Wölbung 12 ermittelt werden. Die konvexe Wölbung 12 soll erfindungsgemäß möglichst um einen Verformungsweg dz in negative Z-Richtung zum Trägersubstrat 2 hin verformt werden, um an dieser X-Y-Position die gewünschte ideale Substratstapeldicke tₛᵢ zu erreichen.

Figur 5b zeigt eine schematische Querschnittsdarstellung der Positionierung derselben konvexen Wölbung 12 unter der Beaufschlagungseinheit 9. Die Positionierung der konvexen Wölbung 12 sollte mit hoher Genauigkeit erfolgen. Die Genauigkeit ist insbesondere besser als 1 mm (maximale Abweichung/Toleranz in X-Y-Richtung), vorzugsweise besser als 100 µm, mit größerem Vorzug besser als 10 µm, mit größtem Vorzug besser als 1 µm.

Figur 5c zeigt eine schematische Querschnittsdarstellung der Verwendung der Beaufschlagungseinheit 9 durch Absenken und dadurch nach Kontaktierung des Beaufschlagungskopfes 9k mit der Oberfläche 4o mechanische Druckbeaufschlagung auf die konvexe Wölbung 12. Hierbei wird die konvexe Wölbung 12 planarisiert. Zur besseren Verformbarkeit der Verbindungsschicht 3 beim Beaufschlagen wird diese bevorzugt geheizt, damit eine möglichst plastische Verformung stattfindet.

Figur 5d zeigt eine schematische Querschnittsdarstellung eines optionalen vierten Messschrittes der erneuten Vermessung derselben Position, um die Abnahme oder sogar das Verschwinden der konvexen Wölbung 12 zu verifizieren oder gegebenenfalls eine erneute Beaufschlagung durchzuführen und/oder die Beaufschlagungseinrichtung 11 zu kalibrieren.

Unter Realbedingungen kann sich zeigen, dass eine Verformung der konvexen Wölbung 12 in negativer Z-Richtung um den Verformungsweg dz auf Grund von Eigenspannungen des Substratstapels oder Fließverhalten der Verbindungsschicht 3 nicht immer exakt möglich ist, sodass durch empirische Messungen mittels der vorbeschriebenen Ausführungsform die idealen Parameter bestimmt werden.

Die in den Figuren 5a-5d dargestellten Prozessschritte werden für alle X-Y-Positionen der gemessenen Maxima des Substratstapels 1 durchgeführt.

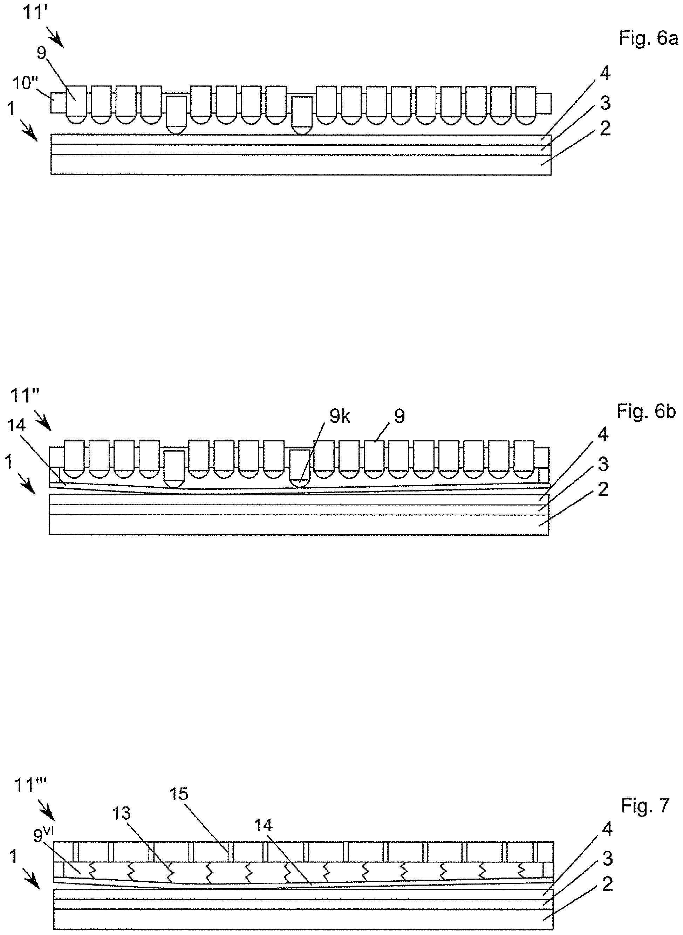

Die Figur 6a zeigt eine bevorzugte Ausführungsform einer als Flächenbeaufschlagungseinrichtung ausgebildeten Beaufschlagungseinrichtung 11', bestehend aus mehreren Beaufschlagungseinheiten 9. Die Beaufschlagungseinheiten 9 sind an einem Strebenköper 10" in Z-Richtung beweglich fixiert, der wiederum an der Grundplatte 6 fixiert ist.

Die Beaufschlagungseinheiten 9 können die Oberfläche 4o des Produktsubstrats 4 oder den Substratstapel 1 entsprechend der Ausführungsform gemäß Figur 3 mechanisch beaufschlagen und so zu einem Abbau der konvexen Wölbungen 12 führen.

Der Gedanke bei der Flächenbeaufschlagungseinrichtung besteht erstens in einem schnelleren Durchsatz und damit geringeren Kosten bei der Prozessierung mehrerer Substrate und zweitens in der Möglichkeit, eine parallele Verformung der Oberfläche 4o des Produktsubstrats 4 und der darunter liegenden Verbindungsschicht 3 durchzuführen. Dies ist vor allem dann notwendig, wenn die Entfernung einer konvexen Wölbung 12 durch eine Beaufschlagungseinheit 9 an einer Stelle zu einem Materialfluss und Erzeugung einer weiteren konvexen Wölbung 12 führt. Durch die gezielte und gesteuerte gleichzeitige Beanspruchung mehrere Punkte der Oberfläche 4o des Produktsubstrats, kann der Materialfluss im Temporärkleber 3 besser gesteuert werden und die Dickenvariation noch effizienter reduziert werden.

Die Beaufschlagungseinheiten 9 sind einzeln ansteuerbar und von einer Ruhestellung in eine Beaufschlagungsstellung in Z-Richtung bewegbar. In der Ruhestellung sind die Beaufschlagungseinheiten 9 fluchtend in einer Ebene parallel zur X-Y-Richtung angeordnet. Die Beaufschlagungseinheiten 9 sind bevorzugt äquidistant zueinander angeordnet und bilden ein Feld von Beaufschlagungseinheiten 9.

Figur 6b zeigt eine Beaufschlagungseinrichtung 11", die eine Erweiterung der Ausführungsform gemäß Figur 6a darstellt. Hier weist die Beaufschlagungseinrichtung 11" eine Membran 14 auf. Die Membran 14 ist an dem Strebenkörper 10" angebracht und überdeckt die Beaufschlagungsköpfe 9k der Beaufschlagungseinheiten 9. Die Beaufschlagungseinheiten 9 verformen die Membran 14 beim Beaufschlagen der Oberfläche 4o und der Kontakt zur Oberfläche 4o des Produktsubstrats 4 erfolgt somit nicht mehr direkt, sondern über die Membran 14. Hierdurch wird eine ähnliche, aber durch die Kontinuität der Membran 13 kontinuierlichere und somit gleichmäßiger verteilte Druckbeaufschlagung erreicht.

Gemäß einer weiteren, in Figur 7 gezeigten Ausführungsform ist eine Beaufschlagungseinrichtung 11''' vorgesehen, die Beaufschlagungseinheiten 9^{VI} in Form von Druckkammern aufweist. Die Druckkammern werden durch elastische Druckkammerwände 13 und die Membran 14 begrenzt. Die Druckkammern sind einzeln steuerbar, indem diese mit Druck beaufschlagt werden. Der Druck wird durch ein Fluid aufgebracht, das über Fluidzugänge 15 in die oder aus der Druckkammer geleitet wird. Bei dem Fluid kann es sich um ein Gas, ein Gasgemisch, eine Flüssigkeit, ein Flüssigkeitsgemisch oder in besonderen Anwendungsfällen ein Gas-Flüssiggemisch handeln.

Die Membran 14 kann zusätzlich zu Ihrer Funktion als Druckübertragungselement, insbesondere ortsaufgelöst angesteuerte, Heizelemente zum Heizen des Substratstapels 1, insbesondere der Verbindungsschicht 3, aufweisen.

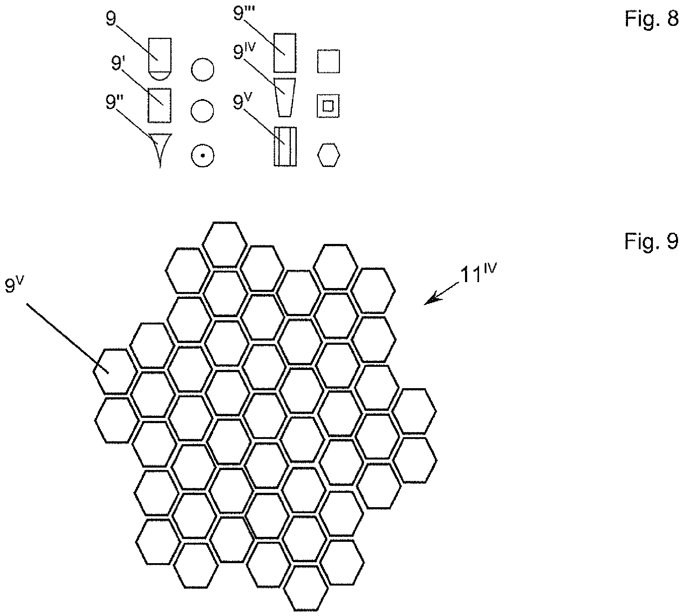

In Figur 8 sind verschiedene alternative Formen für die Beaufschlagungseinheiten 9, 9', 9", 9''', 9^{IV}, 9^{V}, 9^{VI} dargestellt. Mantelflächen der Beaufschlagungseinheiten 9, 9' 9", 9''', 9^{IV}, 9^{V}, 9^{VI} sind bevorzugt als runde, insbesondere kreisrunde (drei Varianten 9, 9', 9" links), oder eckige Zylinder (drei Varianten 9''', 9^{IV,} 9^{V} rechts) geformt.

Die Beaufschlagungsseite (oder Beaufschlagungskopf) ist insbesondere rund zulaufend (Beaufschlagungseinheit 9), flach (Beaufschlagungseinheiten 9', 9'''), spitz zulaufend (Beaufschlagungseinheit 9"), kegelförmig flach zulaufend (Beaufschlagungseinheit 9^{IV}) oder hexagonal flach (Beaufschlagungseinheit 9^{V}) geformt.

In Figur 9 ist eine Ausführungsform einer als Flächenbeaufschlagungseinrichtung ausgebildeten Beaufschlagungseinrichtung 11^{IV} mit einem Feld aus den hexagonalen, flachen Beaufschlagungseinheiten 9^{V} gezeigt. Die Beaufschlagungseinheiten 9^{V} grenzen wabenförmig aneinander an und sind daher von der Aufteilung und Stabilität hervorragend für das erfindungsgemäße Verfahren geeignet.

### Bezugszeichenliste

- 1: Substratstapel
- 2: Erstes Substrat, insbesondere Trägersubstrat
- 3: Verbindungsschicht, insbesondere temporärer Kleber
- 4: Zweites Substrat, insbesondere Produktsubstrat
- 4o: Oberfläche des Produktsubstrats
- 5: Messeinheit
- 6: Grundplatte
- 7: Sender-Empfänger-Einheit
- 8: Probenhalter
- 9, 9', 9": Beaufschlagungseinheiten
- 9''', 9^{IV}: Beaufschlagungseinheiten
- 9^{V}, 9^{VI}: Beaufschlagungseinheiten
- 9k: Beaufschlagungskopf
- 10, 10', 10": Streben, Strebenkörper
- 11, 11', 11": Beaufschlagungseinrichtungen
- 11''', 11^{IV}: Beaufschlagungseinrichtungen
- 12: Konvexe Wölbung, Dickenmaximum
- 13: Druckkammerwand
- 14: Membran
- 15: Fluidzugang
- dz: Verformungsweg
- t: Substratstapeldicke
- tₛᵢ: ideale Substratstapeldicke
- tₛᵣ: reale Substratstapeldicke
- tₜ: Trägersubstratdicke
- tₚ: Produktsubstratdicke

## Patentansprüche

1. Verfahren zur Vergleichmäßigung der Dickenvariation in einem post-Temporärbond Prozess eines aus einem Produktwafer (4) und einem Trägerwafer (2) bestehenden mittels einer Klebeschicht (3) verbundenen Waferstapels (1) durch lokale mechanische Druckbeaufschlagung lokaler Dickenmaxima (12) des Waferstapels (1) mittels einer mindestens eine Beaufschlagungseinheit (9, 9', 9", 9''', 9^{IV}, 9^{V}, 9^{VI}) aufweisenden Beaufschlagungseinrichtung (11, 11', 11"), wobei X-Y-Positionen der Dickenmaxima (12) ermittelt werden, wobei die Dickenmaxima (12) gezielt durch die mindestens eine Beaufschlagungseinheit (9, 9', 9", 9''', 9^{IV}, 9^{V}, 9^{VI}) vergleichmäßigt werden, wobei der Produktwafer (4) durch die mindestens eine Beaufschlagungseinheit (9, 9', 9", 9''', 9^{IV}, 9^{V}, 9^{VI}) lokalen Verformungen ausgesetzt wird, wobei die lokalen Verformungen des Produktwafers (4) zur Vergleichmäßigung der Dickenmaxima (12) des Waferstapels (1) führen, wobei der Produktwafer (4) dünner ist als der Trägerwafer (2), wobei die lokalen Verformungen des Produktwafers (4) zu einem Verfließen der Klebeschicht (3) führen und dadurch eine Vergleichmäßigung der Dicke der Klebeschicht (3) und somit des Waferstapels (1) bewirken.

2. Verfahren nach Anspruch 1, bei dem X-Y-Positionen der lokalen Dickenmaxima (12) vor der lokalen Beaufschlagung mittels einer, insbesondere optisch und/oder akustisch arbeitenden, Messeinheit (5) ermittelt werden.

3. Verfahren nach einem der vorhergehenden Ansprüche, bei dem die Beaufschlagungseinrichtung (11, 11', 11") mehrere, insbesondere separat ansteuerbare und oder diskret angeordnete, Beaufschlagungseinheiten (9, 9', 9", 9''', 9^{IV}, 9^{V}, 9^{VI}) aufweist.

4. Verfahren nach einem der vorhergehenden Ansprüche, bei dem die Beaufschlagungseinrichtung (11, 11', 11") eine, insbesondere die Beaufschlagungseinheiten (9, 9', 9", 9''', 9^{IV}, 9^{V}, 9^{VI}) bedeckende, Membran (14) zur Beaufschlagung der Dickenmaxima (12) aufweist.

5. Verfahren nach einem der vorhergehenden Ansprüche, bei dem die Dickenvariation mindestens halbiert, vorzugsweise um mindestens 75%, noch bevorzugter um mindestens 90%, noch bevorzugter um mindestens 95% reduziert wird.

## Claims

1. A method for evening out the thickness variation in a post-temporary bonding process of a wafer stack (1) comprising a product wafer (4) and a carrier wafer (2) connected by means of an adhesive layer (3), by means of local mechanical application of pressure on local thickness maxima (12) of the wafer stack (1) by means of an application device (11, 11', 11") comprising at least one application unit (9, 9', 9", 9"', 9^{IV}, 9^{V}, 9^{VI}), wherein X-Y positions of the thickness maxima are determined, wherein the thickness maxima (12) are evened out in a targeted manner by means of the at least one application unit (9, 9', 9", 9"', 9^{IV}, 9^{V}, 9^{VI}), wherein the product wafer (4) is subjected to local deformations by means of the at least one application unit (9, 9', 9", 9''', 9^{IV}, 9^{V}, 9^{VI}), wherein the local deformations of the product wafer (4) lead to evening-out of the thickness maxima (12) of the wafer stack (1), wherein the product wafer (4) is thinner than the carrier wafer (2), wherein the local deformations of the product wafer (4) lead to flowing of the adhesive layer (3) and thus bring about evening-out of the thickness of the adhesive layer (3) and therefore of the wafer stack (1).

2. The method according to claim 1, wherein X-Y positions of the local thickness maxima (12) are determined before the local application by means of a measuring unit (5), operating in particular optically and/or acoustically.

3. The method according to any one of the preceding claims, wherein the application device (11, 11', 11") comprises a plurality of, in particular, separately controllable and/or discretely arranged application units (9, 9', 9", 9''', 9^{IV}, 9^{V}, 9^{VI}).

4. The method according to any one of the preceding claims, wherein the application device (11, 11', 11") comprises a membrane (14), in particular covering the application units (9, 9', 9", 9''', 9^{IV}, 9^{V}, 9^{VI}), for application to the thickness maxima (12).

5. The method according to any one of the preceding claims, wherein the thickness variation is at least halved, preferably reduced by at least 75 %, still more preferably by at least 90 %, more preferably still by at least 95 %.

## Revendications

1. Procédé d'uniformisation de la variation d'épaisseur dans un processus post-liaison temporaire d'une pile de plaquettes (1) composée d'une plaquette de produit (4) et d'une plaquette porteuse (2) et connectée au moyen d'une couche de colle (3) par sollicitation à la pression mécanique locale de maxima d'épaisseurs locaux (12) de la pile de plaquettes (1) au moyen d'un dispositif de sollicitation (11, 11', 11") présentant au moins une unité de sollicitation (9, 9', 9", 9''', 9^{IV}, 9^{V}, 9^{VI}), des positions X-Y des maxima d'épaisseur (12) étant déterminées, les maxima d'épaisseur (12) étant uniformisés de manière ciblée par l'au moins une unité de sollicitation (9, 9', 9", 9''', 9^{IV}, 9^{V}, 9^{VI}), la plaquette de produit (4) étant exposée par l'au moins une unité de sollicitation (9, 9', 9", 9''', 9^{IV}, 9^{V}, 9^{VI}) à des déformations locales, les déformations locales de la plaquette de produit (4) entraînant l'uniformisation des maxima d'épaisseur (12) de la pile de plaquettes (1), la plaquette de produit (4) étant plus mince que la plaquette porteuse (2), les déformations locales de la plaquette de produit (4) entraînant un fluage de la couche de colle (3) et provoquant ainsi une uniformisation de l'épaisseur de la couche de colle (3) et donc de la pile de plaquettes (1).

2. Procédé selon la revendication 1, dans lequel les positions X-Y des maxima d'épaisseur locaux (12) sont déterminées avant la sollicitation locale au moyen d'une unité de mesure (5) fonctionnant en particulier par système optique et/ou acoustique.

3. Procédé selon une des revendications précédentes, dans lequel le dispositif de sollicitation (11, 11', 11") présente plusieurs unités de sollicitation (9, 9', 9", 9''', 9^{IV}, 9^{V}, 9^{VI}), en particulier contrôlables séparément et/ou disposées de manière discrète.

4. Procédé selon une des revendications précédentes, dans lequel le dispositif de sollicitation (11, 11', 11") présente une membrane (14), en particulier recouvrant les unités de sollicitation (9, 9', 9", 9''', 9^{IV}, 9^{V}, 9^{VI}), pour la sollicitation des maxima d'épaisseur (12).

5. Procédé selon une des revendications précédentes, dans lequel la variation d'épaisseur est au moins divisée par deux, de préférence réduite d'au moins 75 %, encore plus préférentiellement d'au moins 90 %, encore plus préférentiellement d'au moins 95 %.
